(19) Europäisches Patentamt
European Patent Office
Office européen des brevets

(11) Numéro de publication : **0 283 056 B1**

# (12) FASCICULE DE BREVET EUROPEEN

(45) Date de publication du fascicule du brevet : **06.11.91 Bulletin 91/45**

(51) Int. Cl.$^5$ : **H03H 11/20**

(21) Numéro de dépôt : **88200006.0**

(22) Date de dépôt : **06.01.88**

(54) **Déphaseur actif 0-180o pour hyperfréquences.**

(30) Priorité : **20.01.87 FR 8700567**

(43) Date de publication de la demande : **21.09.88 Bulletin 88/38**

(45) Mention de la délivrance du brevet : **06.11.91 Bulletin 91/45**

(84) Etats contractants désignés : **DE FR GB IT**

(56) Documents cités :
**US-A- 3 246 241**
**JOURNAL OF THE AUDIO ENGINEERING SOCIETY, vol. 32, no. 6, juin 1984, pages 415-421, New York, US; S. TAKAHASHI et al.: "Fully balanced bridge amplifier"**
**GaAs IC SYMPOSIUM TECHNICAL DIGEST 1985, Monterey, Californie, 12-14 novembre 1985, pages 125-128, IEEE, US; Y.K. CHEN et al.: "A GaAs multi-band digitally-controlled 0 degree - 360 degrees phase shifter"**

(73) Titulaire : **LABORATOIRES D'ELECTRONIQUE PHILIPS**
**3, Avenue Descartes**
**F-94450 Limeil-Brévannes (FR)**
**FR**
Titulaire : **N.V. Philips' Gloeilampenfabrieken**
**Groenewoudseweg 1**
**NL-5621 BA Eindhoven (NL)**
**DE GB IT**

(72) Inventeur : **Dautriche, Pierre Société Civile S.P.I.D.**
**209, rue de l'Université**
**F-75007 Paris (FR)**

(74) Mandataire : **Jacquard, Philippe et al**
**Société Civile S.P.I.D. 156, Boulevard Haussmann**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).



Jouve, 18, rue Saint-Denis, 75001 PARIS

## Description

La présente invention a pour objet un déphaseur actif 0-180° pour hyperfréquences.

On connaît déjà un tel déphaseur mettant en oeuvre une cellule différentielle comportant deux transistors à effet de champ dont les sources sont couplées entre elles et sont chargées par une impédance Z dont la valeur est ajustée pour obtenir l'égalité des modules des signaux présents sur les drains des transistors ainsi que la valeur désirée de la phase, soit 180°.

Or un tel ajustage ne peut être obtenu que pour une bande de fréquences limitée et de plus il nécessite d'occuper une surface importante de substrat lorsqu'il est intégré.

La présente invention a pour objet un déphaseur actif mettant en oeuvre des éléments actifs, donc nécessitant une surface de substrat beaucoup moins importante, et qui de plus est susceptible de fonctionner dans une large bande de fréquences, et présentant en outre une bonne réjection de mode commun.

Le principe de base de l'invention consiste à effectuer de manière symétrique la différence de deux signaux provenant des sorties d'un amplificateur différentiel classique.

Dans ce but, l'invention a pour objet un déphaseur actif 0-180° pour hyperfréquences caractérisé en ce qu'il comporte un amplificateur différentiel d'entrée recevant un signal d'entrée et comportant une sortie inverseuse et une sortie non inverseuse et un premier et un deuxième étage de sortie du type push-pull réalisés avec des transistors MESFET, et comportant chacun une entrée inverseuse et une entrée non inverseuse ladite sortie inverseuse attaquant l'entrée inverseuse du premier étage de sortie et l'entrée non inverseuse du deuxième étage de sortie, et ladite sortie non inverseuse attaquant l'entrée non inverseuse du premier étage de sortie et l'entrée inverseuse du deuxième étage de sortie, les sorties des deux étages de sortie constituant les sorties du déphaseur.

Selon un mode de réalisation préféré, l'amplificateur différentiel d'entrée est un amplificateur MESFET à charge active dont les sorties attaquent les entrées respectives du premier et du deuxième étage de sortie à travers des diodes disposées en série de manière à compenser les décalages de niveau continu.

L'invention sera mieux comprise à la lecture de la description qui va suivre donnée à titre d'exemple non limitatif en liaison avec les figures qui représentent:

les figures 1a et 1b, respectivement un déphaseur à cellule différentielle selon l'art antérieur et un schéma de modélisation simplifiée de celui-ci.

les figures 2a et 2b, respectivement un schéma d'un déphaseur selon l'invention et un schéma de modélisation simplifiée d'un des étages de sortie de celui-ci.

la figure 3, un mode de réalisation préféré du déphaseur selon l'invention.

et les figures 4a et 4b un mode de réalisation préféré d'un déphaseur variable selon l'invention.

La figure 1a montre un déphaseur 0-180° de l'art antérieur présentant deux transistors MESFET $T_1$ et $T_2$ couplés par les sources de manière à former une cellule différentielle, une impédance Z étant disposée entre les sources et un pôle de tension d'alimentation. Les drains des transistors sont reliés au pôle de mode commun chacun à travers une résistance R. Une modélisation simplifiée de ce circuit est représentée à la figure 1b. Selon cette modélisation, le transistor $T_1$ est équivalent d'une part, à un condensateur $C_1$ recevant sur une de ses bornes la tension d'entrée e et présentant à ses bornes la tension $VgS_1$ et, d'autre part, à une source de courant contrôlée d'intensité gm $VgS_1$ disposée en série avec la résistance R de drain du transistor $T_1$, et connectée à l'autre borne du condensateur $C_1$. Le transistor $T_2$ est équivalent, d'une part, à un condensateur $C_2$ disposé en parallèle sur la charge Z et présentant à ses bornes la tension $VgS_2$, et, d'autre part, à une source de courant contrôlée d'intensité $gmVgS_2$ disposée en série entre la résistance R de drain du transistor $T_2$ et le réseau parallèle Z,$C_2$.

Il vient alors:

$$VgS_2 = VgS_1 - e$$

$$gmV_{GS2} + gmV_{GS_1} + jC\omega\ V_{GS_1} + (\frac{1}{Z} + jC_2\omega)\ V_{GS_2} = 0$$

$$V' = -R\ gm\ VgS_2$$

$$V = -R\ gm\ VgS_1$$

La résolution du système d'équations donne les valeurs de V' et V:

$$V' = Rgm \frac{gm + jC_1\omega}{\frac{1}{Z} + 2gm + j(C_1 + C_2)\,\omega} e$$

$$V = -Rgm \frac{gm + \frac{1}{Z} + jC_2\omega}{\frac{1}{Z} + 2gm + j(C_1 + C_2)\,\omega} e$$

L'égalité des modules (gains identiques sur les deux branches) et le déphasage de 180° peuvent être obtenus en ajustant l'impédance Z. Cependant, un tel ajustage n'est valable que pour une bande de fréquences limitée et la présence d'éléments passifs impose une perte de place préjudiciable.

Selon la figure 2a, un déphaseur selon l'invention comporte un amplificateur différentiel recevant un signal d'entrée Ve et produisant à sa sortie non inverseuse un signal Va et à sa sortie inverseuse un signal Vb.

Il vient:

$$Va = \alpha V = \frac{Gd + Gc}{2} e$$

$$Vb = \beta V = \frac{-Gd + Gc}{2} e$$

Gd désignant le gain de l'amplificateur différentiel et Gc son gain de mode commun.

Les signaux de sortie $V_1$ et $V_2$ du déphaseur sont produits par deux amplificateurs push-pull équipés de transistors MESFET, le premier comportant des transistors $T_{11}$ et $T_{12}$ recevant respectivement sur leur porte les signaux $\alpha V$ et $\beta V$, et le second des transistors $T_{13}$ et $T_{14}$ recevant respectivement sur leur porte les signaux $\beta V$ et $\alpha V$. Le drain du transistor $T_{11}$ est connecté à un pôle de tension d'alimentation, sa source au drain du transistor $T_{12}$ et la source du transistor $T_{12}$, au pôle de mode commun. Le drain du transistor $T_{13}$ est connecté audit pôle de tension d'alimentation, sa source au drain du transistor $T_{14}$ et la source du transistor $T_{14}$, au pôle de mode commun. Si on considère les amplificateurs push pull comme idéaux, on a:

$$V_1 = (\alpha - \beta) V = GdV_1 \text{ et } V_2 = (\beta - \alpha) V = -GdV_1,$$

ce qui correspond à l'exactitude sur la valeur du module et de la phase et à une réjection totale du mode commun. En pratique, les amplificateurs introduisent des défauts et nous allons maintenant montrer l'intérêt d'utiliser des étages push-pull MESFET dans le cas d'espèce.

Un schéma équivalent simplifié d'un étage push-pull, celui constitué par les transistors $T_{11}$ et $T_{12}$, est représenté à la figure 2b. Pour le transistor $T_{11}$ recevant le signal $\alpha V$, le schéma comporte un condensateur parallèle de valeur Cgd recevant à ses bornes la tension $\alpha V$, un condensateur série de valeur Cgs dont une borne est connectée à la borne non à la masse du condensateur parallèle Cgd et dont l'autre borne est connectée à une borne d'une source de courant contrôlée d'intensité $gmVgs_2$ référencée par rapport au pôle de mode commun, $V'gs_2$ désignant la tension aux bornes du condensateur Cgs. Enfin, une conductance de valeur gd est connectée en parallèle sur la source de courant précitée. Pour le transistor $T_{12}$ recevant le signal $\beta V$, le schéma comporte un condensateur parallèle de valeur Cgs recevant à ses bornes la tension $\beta V$ (égale à $V'gs_1$ par définition), un condensateur série de valeur Cgd dont une borne est connectée à la borne non à la masse du condensateur parallèle Cgs précité et dont l'autre borne est connectée à une borne d'une source de courant contrôlée d'intensité gm $Vgs_1$ référencée par rapport au pôle de mode commun. Enfin une conductance de valeur gd est connectée en parallèle sur la source de courant précitée.

La tension de sortie $V_1$ est celle présente à la borne commune des condensateurs série et des conductances de valeur gd.

On a:

$$Vgs_1 = \beta V$$
$$Vgs_2 = \alpha V - V_1$$

$$-gmVgs_1 + gmVgs_2 - gV_1 + (\beta V - V_1)\, j\omega\, Cgd + (\alpha V - V_1) j\omega Cgs = 0 \text{ avec } g = 2gd.$$

D'où:

$$V_1 = \frac{gm(\alpha-\beta)}{G} V + j\omega \frac{(Cgd\beta + Cgs\alpha)}{G} V$$

avec

$$gm + g + j\omega (Cgs + Cgd) = G$$

Pour obtenir la valeur de $V_2$, il suffit d'inverser $\alpha$ et $\beta$ dans la formule précédente. d'où:

$$V_2 = - \frac{gm(\alpha-\beta)}{G} V + j\omega \frac{(Cgd\alpha + Cgs\beta)}{G} V$$

En remplaçant $\alpha$ et $\beta$ par leur valeur:

$$\alpha = \frac{Gc + Gd}{2} \qquad \beta = \frac{-Gd + Gc}{2},$$

on a:

$$V_1 = \frac{gm}{G} GdV + \frac{j\omega}{2G} Gc (Cgd + Cgs)V + \frac{j\omega}{2G} Gd(Cgs - Cgd)V$$

$$V_2 = -\frac{gm}{G} GdV + \frac{j\omega}{2G} Gc (Cgd + Cgs)V + \frac{j\omega}{2G} Gd(Cgd - Cgs)V$$

c'est-à-dire:

$$V_1 = [gm + \frac{j\omega}{2} (Cgs - Cgd)] \frac{GdV}{G} + \frac{j\omega}{2G} Gc (Ggd + Cgs)V$$

$$V_2 = -[gm + \frac{j\omega}{2} (Cgs - Cgd)] \frac{GdV}{G} + \frac{j\omega}{2G} Gc (Ggd + Cgs)V$$

On obtient une réduction du gain de mode commun à raison d'un facteur multiplicatif k de module inférieur à 1:

$$k = \frac{j\omega (Cgd + Cgs)}{G}$$

En ce qui concerne le déphasage, sa valeur est exacte pour f = 0 et se dégrade progressivement en hautes fréquences. On peut montrer que l'amélioration peut s'exprimer sous la forme équivalente du facteur K:

$$K = \frac{1}{\sqrt{1 + (\frac{ft}{f})^2}}$$

$$\text{avec } ft = \frac{gm}{2\pi Cgs}$$

On obtient donc une amélioration en ce qui concerne la phase jusqu'à la fréquence de coupure du transistor.

Selon la figure 3, le déphaseur comporte un étage différentiel d'entrée comprenant deux transistors MESFET dont les sources sont couplées et connectées à une source de courant constituée par un transistor $T_{28}$ dont la grille et la source sont connectées au pôle de tension d'alimentation négative $U_3$, (par exemple – 4V), et le drain connecté aux sources des transistors $T_{21}$ et $T_{23}$ précités. La tension d'entrée Ve est appliquée à la grille du transistor $T_{21}$ à travers un réseau de découplage comportant un condensateur série $C_4$ et une résistance parallèle $R_2$ entre la grille du transistor $T_{21}$ et le pôle de mode commun. La grille du transistor $T_{23}$ est directement référencée au pôle de mode commun.

Afin d'obtenir un gain en dynamique tout en conservant un gain en continu de l'ordre de l'unité, les drains de transistors $T_{21}$ et $T_{23}$ sont associés à une charge active constituée par un transistor MESFET respectivement $T_{22}$ et $T_{24}$ dont la source est connectée au drain du transistor correspondant, et comportant un condensateur $C_3$ de faible valeur (de l'ordre du picofarad) connecté entre leur source et leur grille. La grille de chacun des transistors $T_{22}$ et $T_{24}$ est reliée à un pôle de tension d'alimentation $U_1$ (par exemple + 1,5V) à travers une résistance $R_1$, alors que leur drain est connecté à un pôle de tension d'alimentation $U_2$ (par exemple + 4V).

Des transistors $T_{25}$ et $T_{26}$ montés en suiveur et dont le drain est directement référencé à la source de tension $U_2$ reçoivent sur leur porte les tensions de drain respectivement des transistors $T_{21}$ et $T_{23}$. Les sources des transistors $T_{25}$ et $T_{26}$ sont connectés chacun à un groupe de plusieurs diodes D en série, ici au nombre de 4, de manière à réaliser une adaptation de niveau pour les étages push-pull de sortie. Des transistors $T_{27}$ et $T_{29}$ montés en source de courant de manière analogue au transistor $T_{28}$ ont leur drain connecté à la cathode de la dernière diode de chaque groupe, de manière à définir le courant traversant les diodes et donc la chute de tension dans celles-ci.

La source des transistors $T_{25}$ et $T_{26}$ est reliée à la porte respectivement des transistors $T_{13}$ et $T_{11}$ avec une chute de tension d'une diode, et à la porte respectivement des transistors $T_{12}$ et $T_{14}$ avec une chute de tension dans la totalité des diodes, à savoir quatre, ce qui permet de polariser correctement les étages de sortie. On pourra prendre dans cette configuration $U_1 = 1{,}5V$, $U_2 = 6V$ et $U_3 = -4V$.

Les figures 4a et 4b représentent un mode de réalisation préféré de l'invention dans lequel la valeur de l'écart de phase entre les sorties du déphaseur peut varier entre 0 et 180°.

Selon la figure 4a, un module déphaseur ($\phi_1$,$\phi_2$) comporte deux branches en parallèle recevant le signal d'entrée. La première branche parallèle comporte un amplificateur $A_5$ dont la sortie est chargée par deux résistances de même valeur en série $R_5$ et $R'_5$, $R'_5$ ayant une borne connectée au pôle de mode commun. La borne commune aux résistances $R_5$ et $R'_5$ constitue la sortie de la première branche. La deuxième branche parallèle comporte un amplificateur inverseur $A_6$ dont la sortie est chargée par une résistance variable $R_6$ dont la valeur est commandée par une tension V'e et un condensateur $C_6$ dont une borne est connectée au pôle de mode commun. La borne commune à la résistance $R_6$ et au condensateur $C_6$ constitue la sortie de la deuxième branche.

Les sorties des deux branches sont additionnées par un sommateur 40 dont la sortie fournit un signal S.

On a alors avec $R_5 = R'_5$ et les deux amplificateurs $A_5$ et $A_6$ ayant le même gain A:

$$S = \frac{AVe}{2} - \frac{AVe}{jC_6\omega} \quad \frac{1}{R_6 + \frac{1}{jC_6\omega}}$$

soit :

$$S = \frac{-AVe}{2} \quad \frac{1 - \tau p}{1 + \tau p}$$

Le déphasage pour une fréquence donnée dépend de la constante de temps $\tau = R_6C_6$.

On a:

$$|\frac{S}{e}| = \frac{A}{2};\ \Delta\phi = 180° - 2 \text{ Arc tg } p\tau$$

On peut ainsi décrire un écart de phase $\Delta\phi$ variant de 0 à 180° suivant la valeur de $\tau$, donc de $R_6$.

La figure 6b décrit un mode de réalisation particulièrement avantageux du déphaseur dans lequel l'écart de phase peut être réglé entre 0 et 180°, mettant en oeuvre un étage différentiel d'entrée MESFET à charge active, et un étage de sortie pour chaque amplificateur, mettant en oeuvre des transistors MESFET montés en push-pull, ce qui permet d'optimiser la tension résiduelle de mode commun.

On obtient donc une amélioration en ce qui concerne la phase jusqu'à la fréquence de coupure du transistor.

Les éléments similaires portent sur la figure 4b les mêmes références que sur la figure 3.

Les résistances $R_5$ et $R'_5$ sont raccordées en série entre la sortie de l'étage push-pull $T_{11}$, $T_{12}$ et le pôle de mode commun avec interposition éventuelle d'un condensateur de découplage $C_5$ de faible valeur. La résistance variable $R_6$ est la résistance drain-source d'un transistor MESFET $T_{36}$ dont le drain est connecté à la sortie de l'étage push-pull $T_{13}$, $T_{14}$ et dont la source est connectée à la borne non à la masse du condensateur $C_6$. La grille du transistor $T_{36}$ reçoit une tension $V'_e$.

Enfin, le sommateur 40 est constitué par deux transistors MESFET $T_{31}$ et $T_{32}$ dont les drains sont connectés à la source de tension d'alimentation $U_2$, dont les sources sont couplées entre elles et connectées au transistor $T_{33}$ monté en source de courant de manière analogue au transistor $T_{28}$. La source du transistor $T_{36}$ est connectée à la grille du transistor $T_{32}$ et la borne commune aux résistances $R_5$ et $R'_5$, à la grille du transistor $T_{31}$, ce qui fait que la somme de leurs tensions apparaît sur les sources des transistors $T_{31}$ et $T_{32}$. (signal S).

Pour faire varier l'écart de phase entre 0 et 180°, il faut faire varier la tension V'e jusqu'à atteindre la tension de pincement du canal du transistor $T_{36}$.

## Revendications

1. Déphaseur actif 0-180° pour hyperfréquences caractérisé en ce qu'il comporte un amplificateur différentiel d'entrée recevant un signal d'entrée et comportant une sortie inverseuse et une sortie non-inverseuse, et un premier et un deuxième étage de sortie du type push-pull réalisés avec des transistors MESFET, et comportant chacun une entrée inverseuse et une entrée non-inverseuse, ladite sortie inverseuse attaquant l'entrée inverseuse du premier étage de sortie et l'entrée non-inverseuse du deuxième étage de sortie, et ladite sortie non-inverseuse attaquant l'entrée non-inverseuse du premier étage de sortie et l'entrée inverseuse du deuxième étage de sortie, les sorties des deux étages de sortie constituant les sorties du déphaseur.

2. Déphaseur selon la revendication 1, caractérisé en ce que l'amplificateur différentiel d'entrée est un amplificateur MESFET à charge active dont les sorties attaquent les entrées respectives du premier et du deuxième étage de sortie et en ce qu'il comporte des diodes disposées en série sur les sorties dudit amplificateur MESFET, au moins certaines des entrées du premier et du deuxième étage de sortie étant raccordées auxdites sorties de l'amplificateur MESFET à travers au moins une desdites diodes de manière à compenser les décalages de niveau.

3. Déphaseur selon une des revendications 1 ou 2 caractérisé en ce que la sortie du premier étage de sortie est chargée par le trajet drain-source d'un premier transistor dont la grille reçoit un signal de commande, en série avec un condensateur, la sortie du deuxième étage de sortie étant chargée par une première et une deuxième résistance en série, et en ce que les tensions présentes à la borne commune au trajet drain-source du premier transistor et au condensateur d'une part et à la borne commune aux première et deuxième résistance d'autre part, sont additionnées par un circuit sommateur dont la sortie délivre ainsi un signal dont la phase varie en fonction du signal de commande.

## Patentansprüche

1. 0-180°-aktiver Phasenschieber für Mikrowellenfrequenzen, dadurch gekennzeichnet, daß er einen ein Eingangssignal erhaltenden Eingangs-Differentialverstärker mit einem invertierenden und einem nicht-invertierenden Ausgang hat, sowie eine erste und eine zweite Gegentakt-Ausgangsstufe mit MESFET-Transistoren, die je einen invertierenden und einen nicht-invertierenden Eingang aufweisen, wobei der genannte invertierende Ausgang den invertierenden Eingang der ersten Ausgangsstufe sowie den nicht-invertierenden Eingang der zweiten Ausgangsstufe betreibt, wobei der genannte nicht-invertierende Ausgang den nicht-invertierenden Eingang der ersten Ausgangsstufe und den invertierenden Eingang der zweiten Ausgangsstufe betreibt, wobei die Ausgänge der beiden Ausgangsstufen die Ausgänge des Phasenschiebers bilden.

2. Phasenschieber nach Anspruch 1, dadurch gekennzeichnet, daß der Eingangs-Differentialverstärker ein MESFET-Verstärker mit aktiver Belastung ist, dessen Ausgangssignale die Eingänge der ersten bzw. zweiten Ausgangsstufe betreiben, und daß er mit den Ausgängen des genannten MESFET-Verstärkers in Reihe geschaltete Dioden ausweist, wobei mindestens einige der Eingänge der ersten und zweiten Ausgangsstufe über mindestens eine der genannten Dioden derart mit den genannten Ausgängen des MESFET-Verstärkers verbunden sind, daß die Pegelverschiebungen ausgeglichen werden.

3. Phasenschieber nach Anspruch 1 oder 2, dadurch gekennzeichnet, daß der Ausgang der ersten Ausgangsstufe durch die Drain-Source-Strecke eines ersten Transistors belastet wird, dessen Gate-Elektrode ein

Steuersignal erhält, wobei in Reihe mit einem Kondensator der Ausgang der zweiten Ausgangsstufe durch einen ersten und einen damit in Reihe geschalteten zweiten Widerstand belastet wird, und daß die an der gemeinsamen Klemme in der Drain-Source-Strecke des ersten Transistors und an dem Kondensator einerseits und an der gemeinsamen Klemme des ersten und zweiten Widerstandes andererseits vorhandenen Spannungen durch eine Summierschaltung addiert werden, deren Ausgang ebenfalls ein Signal liefert, dessen Phase in Funktion des Steuersignals variiert.

## Claims

1. An active 0-180° ultra-high frequency phase shifter, characterized in that it comprises a differential input amplifier receiving an input signal and having an inverting output and a non-inverting output, and a first and a second output stage of the push-pull type realized with MESFET transistors, each stage comprising an inverting input and a non-inverting input, said inverting output controlling the inverting input of the first output stage and the non-inverting input of the second output stage and said non-inverting output controlling the non-inverting input of the first output stage and the inverting input of the second output stage, the outputs of the two output stages constituting the outputs of the phase shifter.

2. A phase shifter as claimed in Claim 1, characterized in that the differential input amplifier is a MESFET amplifier having an active charge whose outputs control the respective inputs of the first and the second output stage and in that it comprises diodes arranged in series with the outputs of said MESFET amplifier, while at least a certain number of the inputs of the first and the second output stage are connected to said outputs of the MESFET amplifier via at least one of said diodes so as to compensate for level shifts.

3. A phase shifter as claimed in any one of Claim 1 or 2, characterized in that the output of the first output stage is charged by the drain-source path of a first transistor whose gate receives a control signal, in series with a capacitor, the output of the second output stage being charged by a first and a second resistor arranged in series, and in that the voltages present at the common terminal of the drain-source path of the first transistor and the capacitor on the one hand and at the common terminal of the first and the second resistor on the other hand are combined by a summation circuit whose output supplies a signal whose phase varies as a function of the control signal.

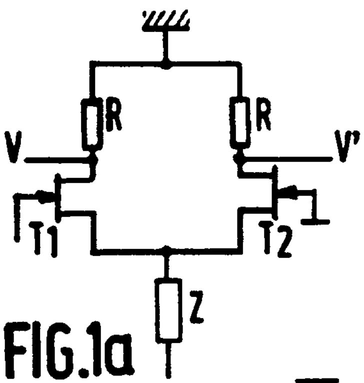


FIG.1a

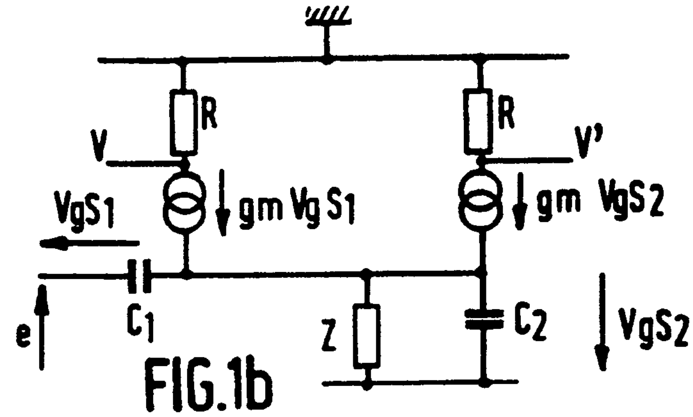


FIG.1b

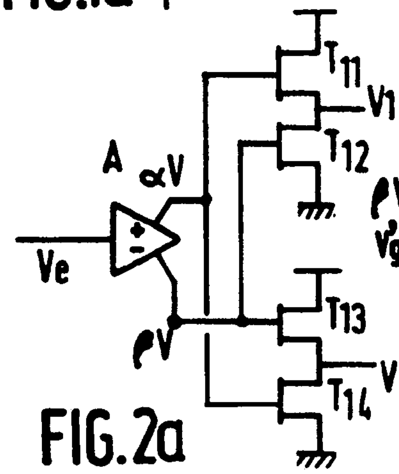


FIG.2a

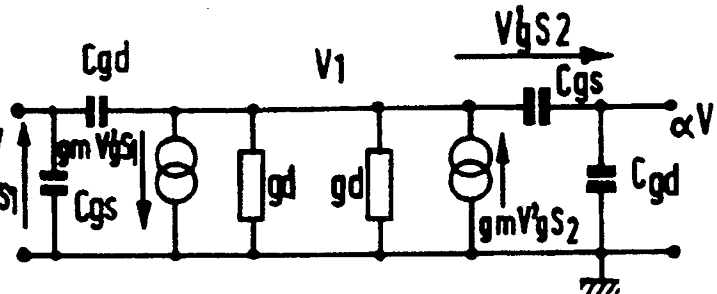


FIG.2b

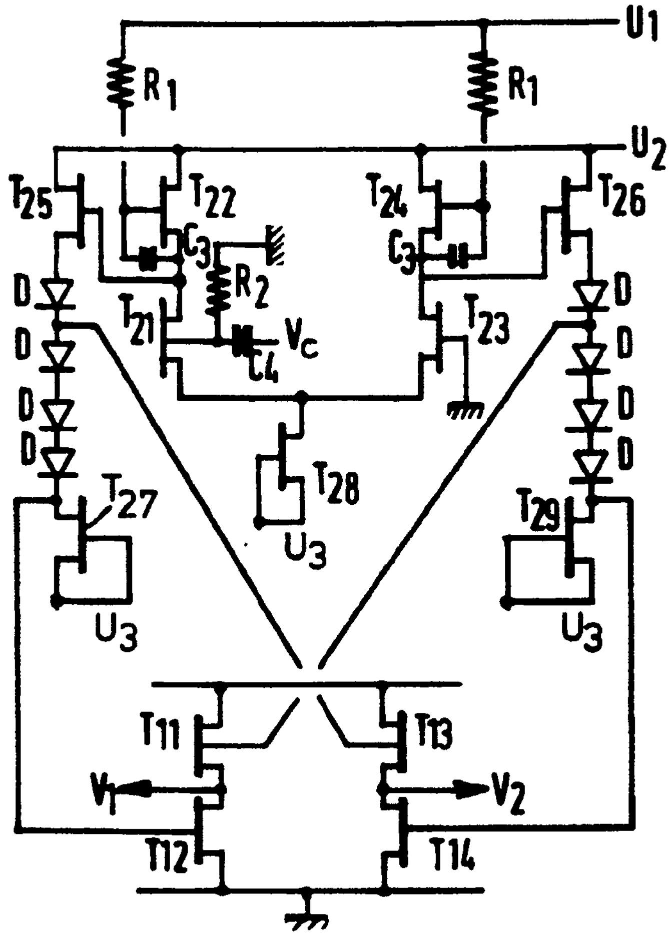


FIG.3

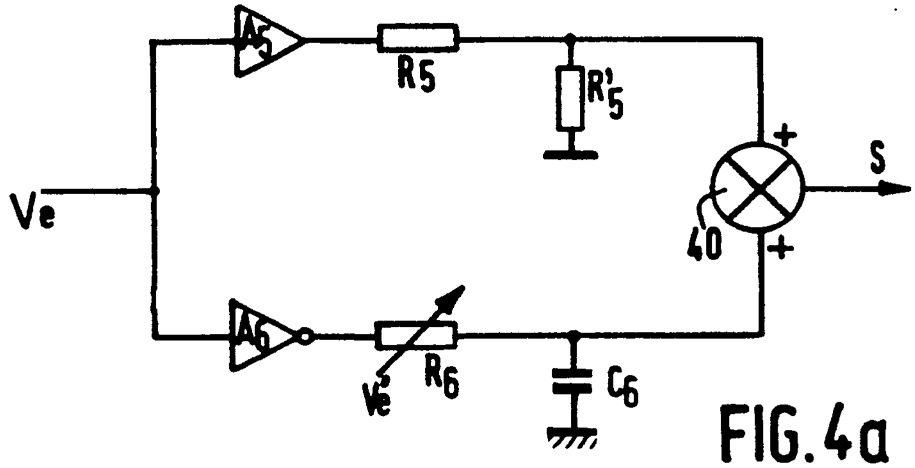

Ve
A5
R5
R'5
+
S
40
+
A6
R6
Ve'
C6


FIG.4a

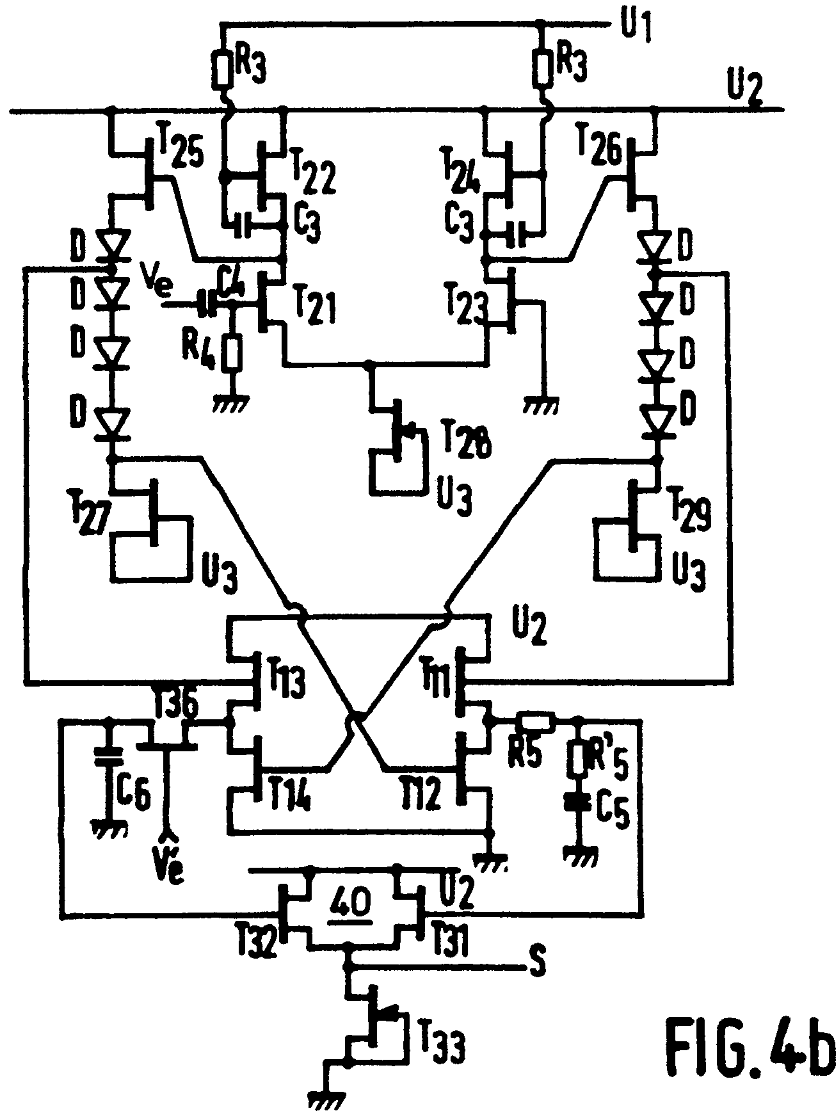

U1
R3
R3
U2
T25
T22
C3
T24
C3
T26
D
D
Ve
C4
T21
T23
D
D
R4
D
D
D
D
T28
U3
T27
U3
T29
U3
U2
T13
T11
T36
R5
R'5
C6
T14
T12
C5
Ve'
40
U2
T32
T31
S
T33


FIG.4b